# FASCICULE DE BREVET EUROPEEN

(11) **EP 2 458 705 B1**
(45) Date de publication et mention de la délivrance du brevet: **02.01.2019**
(21) Numéro de dépôt: 10192609.5
(22) Date de dépôt: 25.11.2010
(51) Int. Cl.: H02J 7/00, G01R 31/36

(54) **Systeme de mesure des cellules d'une pile a combustible**
Messsystem der Zellen einer Brennstoffzelle
System for measuring the cells of a fuel cell

(43) Date de publication de la demande: 30.05.2012
(73) Titulaire: Belenos Clean Power Holding AG, 2502 Bienne (CH)
(72) Inventeur: Toth, Antoine, 2800, Delémont (CH)
(74) Mandataire: Ravenel, Thierry Gérard Louis

(56) Documents cités:
- WO-A1-2008/108979
- WO-A2-2010/032995
- US-A1- 2007 285 083
- US-A1- 2008 164 880
- US-A1- 2008 309 317
- US-B1- 6 472 880
- US-B1- 7 755 326

## Description

La présente invention concerne un système électrochimique. Ce système comprend une pile de blocs électrochimiques reliés en série. Le système est commandé par un circuit de commande et comprend une pluralité d'amplificateurs différentiels connectés chacun par deux entrées aux bornes d'un bloc électrochimique afin de fournir une tension représentative de la différence de potentiel présente entre bornes dudit bloc électrochimique. Chaque tension représentative est envoyée à une unité de contrôle agencée pour convertir cette tension représentative en une valeur numérique transmise au circuit de commande.

### ARRIERE PLAN TECHNOLOGIQUE

Le document WO 2010 032995 montre un système électrochimique comprenant une pile de blocs électrochimiques reliés en série, le système étant commandé par un circuit de commande et comprenant une unité de contrôle agencée pour convertir cette tension représentative en une valeur numérique transmise au circuit de commande, un moyen tampon commandé par le circuit de commande, le moyen tampon étant capable de sauvegarder la tension représentative de la différence de potentiel présente entre les bornes du bloc électrochimique auquel il est relié. On connaît des assemblages de blocs électrochimiques reliés en série (souvent appelés piles). Les blocs électrochimiques ainsi assemblés peuvent être constitués par exemple par des éléments d'accumulateur, ou encore par des cellules à combustible. Une cellule à combustible est un dispositif électrochimique prévu pour convertir une énergie chimique directement en énergie électrique. Par exemple, un type de cellule à combustible inclus une anode et une cathode entre lesquelles est arrangée une membrane à échange de proton souvent appelée membrane électrolyte polymère. Ce type de membrane permet de ne laisser passer que les protons entre l'anode et la cathode de la cellule à combustible. Au niveau de l'anode, de l'hydrogène diatomique subit une réaction afin de produire des ions H⁺ qui vont passer à travers la membrane électrolyte polymère. Les électrons produits par cette réaction rejoignent la cathode par un circuit externe à la cellule à combustible, produisant ainsi un courant électrique.

Du fait qu'une seule cellule à combustible ne produit, en général, qu'une faible tension (environ 1 Volt), on assemble souvent les cellules à combustible en série de manière à constituer des piles de cellules à combustible capables de produire une tension plus élevée qui est l'addition des tensions de chaque cellule. Un inconvénient des piles à combustible est qu'il ne suffit pas de les débrancher pour les arrêter. En effet, si le courant fourni en sortie par une pile à combustible est soudainement réduit à zéro, les cellules à combustible qui constituent la pile ne parviennent plus à éliminer l'énergie électrochimique qu'elles produisent, et la tension aux bornes des différentes cellules risque de s'élever au point d'entraîner une dégradation accélérée de la membrane polymère et des catalyseurs qui lui sont associés. Il ne suffit pas non plus de couper l'alimentation en carburant et en comburant pour stopper une pile à combustible. Dans ce cas, en effet, la quantité de carburant et de comburant enfermée à l'intérieur de la pile suffit à entretenir la réaction pendant un temps considérable. Dans le cas d'une pile à combustible utilisant l'hydrogène comme carburant et l'oxygène pur comme comburant, la pile peut même prendre plusieurs heures pour s'arrêter.

Il est donc avantageux de munir les systèmes à blocs électrochimiques, comme les piles à combustible, de dispositifs de mesure permettant de surveiller la tension produite par chaque cellule de sorte à détecter toute variation lorsque le système à blocs électrochimiques est en fonctionnement constant ou lorsqu'il se trouve en phase d'arrêt.

Il est connu des dispositifs de mesure dit asynchrone se présentant sous deux formes.

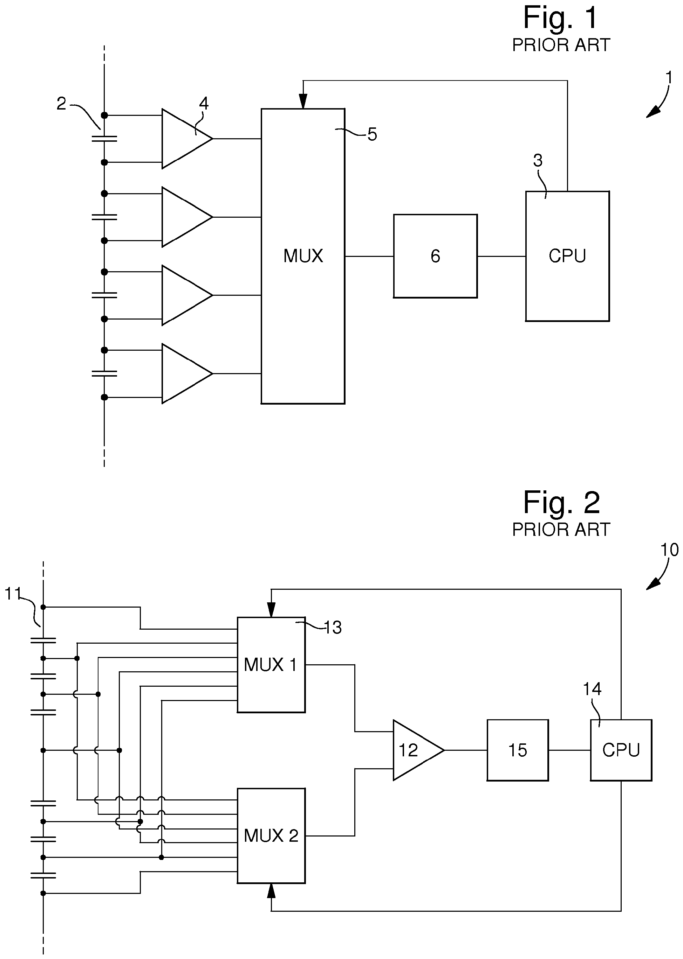

Dans la première forme illustrée par la figure 1, le système 1 à blocs électrochimiques comprend une pluralité d'amplificateurs différentiels 4 connectés chacun par deux entrées aux bornes d'un bloc électrochimique 2 afin de fournir une tension représentative de la différence de potentiel entre les bornes dudit bloc électrochimique 2. Ces amplificateurs 4 différentiels sont connectés, en sortie, à un multiplexeur 5 dont la sortie est reliée à un convertisseur analogique numérique 6. Le multiplexeur 5 est alors commandé pour sélectionner séquentiellement chaque amplificateur différentiel 4 afin que la tension représentative de la différence de potentiel présente entre les bornes dudit bloc électrochimique 2 auquel il est relié, puisse être envoyée au convertisseur analogique numérique 6. Celui-ci numérise alors ladite tension et l'envoie vers un processeur ou CPU 3 qui récupère toutes les tensions représentatives numérisées pour ensuite les interpréter.

Dans la seconde forme illustrée par la figure 2, le système 10 à blocs électrochimiques comprend un premier MUX1 et un second MUX2 multiplexeur 13, la borne positive de chaque bloc 11 étant connectée à l'entrée du premier multiplexeur 13 et la borne négative de chaque bloc 11 étant connectée à l'entrée du second multiplexeur. La sortie de chaque multiplexeur 13 est connectée à une entrée d'un amplificateur différentiel 12. La mesure de la tension représentative de la différence de potentiel entre les bornes d'un bloc électrochimique 11 est effectuée en sélectionnant, via les premiers et seconds multiplexeurs 13, les potentiels correspondant audit bloc électrochimique 11. Ces potentiels sont envoyés à l'amplificateur différentiel 12 afin de fournir ladite tension représentative de la différence de potentiel. La mesure de la tension représentative de la différence de potentiel entre les bornes du bloc électrochimique 11 suivant est ensuite envoyée à un convertisseur analogique numérique 15. Celui-ci numérise alors ladite tension et l'envoie vers un processeur ou CPU 14 qui récupère toutes les tensions représentatives numérisées pour ensuite interpréter ces données.

Or, l'inconvénient de ces deux formes est qu'elles sont asynchrones. En effet, le procédé utilisé dans ces deux formes effectue les mesures les unes après les autres. De ce fait, dans le cas d'une pile de blocs électrochimiques comprenant une centaine de blocs électrochimiques, il faut effectuer la mesure de la tension des cent blocs électrochimiques afin d'avoir la tension représentative de tous les blocs électrochimiques de la pile. En conséquence, avant de pouvoir de nouveau faire la mesure de la tension du premier bloc électrochimique, il faut donc effectuer la mesure de la tension représentative pour l'ensemble des blocs électrochimiques. Il y a donc un intervalle de temps trop important entre deux mesures de la tension représentative du même bloc électrochimique.

De plus, ce procédé induit un décalage temporel entre deux mesures de tension de deux blocs électrochimiques contigus. Cela implique qu'il n'est pas possible d'avoir, à un instant déterminé, l'état de tous les blocs électrochimiques puisque la mesure de la tension représentative de deux blocs électrochimiques contigus n'est pas réalisée lorsque les blocs électrochimiques sont dans le même état, un décalage de temps étant apparus. Il existe donc un risque qu'une variation de tension de l'un des blocs électrochimiques ne soit pas détectée et entraîne des dommages du système à blocs électrochimiques. Et même lorsqu'un problème est détecté, il n'y a aucun moyen de savoir quel bloc électrochimique est défectueux puisque la tension à leurs bornes peut varier suivant les conditions de fonctionnement.

### RESUME DE L'INVENTION

Un but de la présente invention est de fournir un système électrochimique comprenant une pile de blocs électrochimiques dans lequel les mesures d'une tension représentative de la différence de potentiel présente entre les bornes des blocs électrochimiques sont fiables et instantanées et permettant une détection simple et efficace d'un problème au niveau d'un ou plusieurs blocs.

A cet effet, l'invention a pour objet un système électrochimique selon la revendication 1.

Un avantage de la présente invention est de permettre de mesurer la tension de chaque bloc de façon simultanée de sorte à obtenir, à un instant précis, les tensions de tous les blocs électrochimiques. Après avoir récupéré, à différents instants, l'image de la tension de tous les blocs électrochimiques, l'utilisateur peut alors comparer ces images représentatives de la pile de blocs électrochimiques. Il peut alors facilement détecter un problème du à une variation de tension d'un ou de plusieurs blocs électrochimiques mais aussi facilement détecter le ou les blocs électrochimiques défectueux.

Des modes de réalisation avantageux du système électrochimique selon la présente invention font l'objet de revendications dépendantes.

Dans un premier mode de réalisation avantageux, chaque moyen tampon comprend des premiers moyens de commutations et des seconds moyens de commutation montés en séries entre l'amplificateur auquel le moyen tampon est connecté et l'unité de contrôle, chaque moyen tampon comprenant en outre un condensateur dont l'entrée est connectée au point de connexion entre les premiers et seconds moyens de commutations et donc la sortie est reliée à un point de référence.

Dans un second mode de réalisation avantageux, l'ensemble des seconds moyens de commutation est regroupé sous la forme d'un multiplexeur dont chaque entrée est connectée aux premiers moyens de commutations d'un moyen tampon, la sortie du multiplexeur étant connectée à une entre de l'unité de contrôle.

Dans un troisième mode de réalisation avantageux, que ladite pile de blocs électrochimiques est subdivisée en différents groupes comprenant plusieurs blocs électrochimiques associés chacun avec un amplificateur différentiel et un moyen tampon, et une unité de contrôle reliée à la sortie des moyens tampon associés à chaque blocs électrochimiques du groupe, et en ce que chaque groupe a sa propre référence de tension En effet, la division des blocs électrochimiques en groupes de plusieurs blocs électrochimiques permet de limiter la différence de potentielle entre les blocs d'une même série. De plus, chaque groupe ayant sa propre tension de référence, la différence de potentiel entre les différents blocs d'une même série et la tension de référence du groupe de contrôle associé à cette série peut être maintenue dans une gamme compatible avec les dispositifs semi-conducteurs ordinaires.

Dans un autre mode de réalisation avantageux, la référence de tension de chaque groupe est prise sur l'une des bornes d'un bloc électrochimique appartenant audit groupe.

Dans un autre mode de réalisation avantageux, les seconds moyens de commutation des blocs appartenant au même groupe sont regroupés sous la forme d'un multiplexeur dont chaque entrée est connectée aux premiers moyens de commutations d'un moyen tampon, la sortie du multiplexeur étant connectée à une entrée de l'unité de contrôle dudit groupe.

Dans un autre mode de réalisation avantageux, l'unité de contrôle de chaque groupe est relié au circuit de commande par l'intermédiaire de moyens de communication.

Dans un autre mode de réalisation avantageux, les premiers moyens de commutations de chaque moyen tampon se présentent sous la forme d'un transistor piloté par un signal de commande.

Dans un autre mode de réalisation avantageux, les seconds moyens de commutations de chaque moyen tampon se présentent sous la forme d'un transistor piloté par un signal de commande.

Dans un autre mode de réalisation avantageux, le signal de commande de chaque transistor est envoyé par le circuit de commande.

Dans un autre mode de réalisation avantageux, le signal de commande de chaque transistor est envoyé par l'unité de contrôle.

Dans un autre mode de réalisation avantageux, l'unité de contrôle comprend au moins un moyen de conversion analogique numérique agencé pour numériser la valeur de la tension représentative de la différence de potentiel présente entre les bornes de chaque bloc électrochimique.

Dans un autre mode de réalisation avantageux, l'unité de contrôle comprend un nombre de moyens de conversion analogique numérique égal au nombre de moyens tampons, chaque moyen tampon étant relié à un moyen de conversion analogique numérique.

Dans un autre mode de réalisation avantageux, l'unité de contrôle de chaque groupe comprend au moins un moyen de conversion analogique numérique agencé pour numériser la valeur de la tension représentative de la différence de potentiel présente entre les bornes de chaque bloc électrochimique dudit groupe.

Dans un autre mode de réalisation avantageux, l'unité de contrôle de chaque groupe comprend un nombre de moyens de conversion analogique numérique égal au nombre de moyens tampons dudit groupe, chaque moyen tampon étant relié à un moyen de conversion analogique numérique.

De plus, cette division des blocs électrochimiques en plusieurs séries associées chacune à une unité de contrôle permet d'envisager un traitement de l'information plus rapide. Il est possible de réaliser les conversions analogiques-numériques en parallèle. Cela signifie que chaque groupe de blocs électrochimiques numérise, en même temps, les tensions représentatives de la différence de potentiel présente entre les bornes du chaque bloc électrochimique dudit groupe. Cela permet alors de gagner du temps et, ainsi, une cadence de mesure plus importante peut être envisagée offrant une surveillance améliorée.

L'invention a également pour objet un procédé de gestion selon la revendication 16.

Dans un mode de réalisation avantageux, l'étape de traitement des valeurs de tension représentative de la différence de potentiel présente entre les bornes de chaque bloc électrochimique consiste à fermer séquentiellement sur les seconds moyens de commutation de chaque moyen tampon afin de transférer la valeur sauvegarder dans chaque condensateur vers l'unité de contrôle.

Dans un autre mode de réalisation avantageux, ladite pile de blocs électrochimiques (102) est subdivisée en différents groupes comprenant plusieurs blocs électrochimiques associés chacun avec un amplificateur différentiel et un moyen tampon, et une unité de contrôle reliée à la sortie des moyens tampon, chaque groupe ayant sa propre référence de tension et en ce que les étapes du deuxième mode de fonctionnement sont réalisées pour chaque groupe de façon séquentielle.

Dans un autre mode de réalisation avantageux, les étapes du deuxième mode de fonctionnement sont réalisées, pour chaque groupe, de façon simultanée.

### BREVE DESCRIPTION DES FIGURES

Les buts, avantages et caractéristiques du système électrochimique selon la présente invention apparaitront plus clairement dans la description détaillée suivante d'au moins une forme de réalisation de l'invention donnée uniquement à titre d'exemple non limitatif et illustrée par les dessins annexés sur lesquels :
- les figures 1 et 2 représentent de manière schématique le système électrochimique selon l'art antérieur ;
- la figure 3 représente de manière schématique le système électrochimique selon un premier mode de réalisation de la présente invention ;
- les figures 4 et 5 représentent de manière schématique les moyens tampons du système selon la présente invention ;
- la figure 6 représente de manière schématique une variante du système électrochimique selon le premier mode de réalisation de la présente invention ;
- la figure 7 représente de manière schématique le système électrochimique selon un second mode de réalisation de la présente invention ; et
- la figure 8 représente de manière schématique une variante du système électrochimique selon le second mode de réalisation de la présente invention ;

### DESCRIPTION DETAILLEE

Dans la description suivante, toutes les parties d'une pile à combustible connues d'un homme du métier dans ce domaine technique ne seront expliquées que de manière simplifiée.

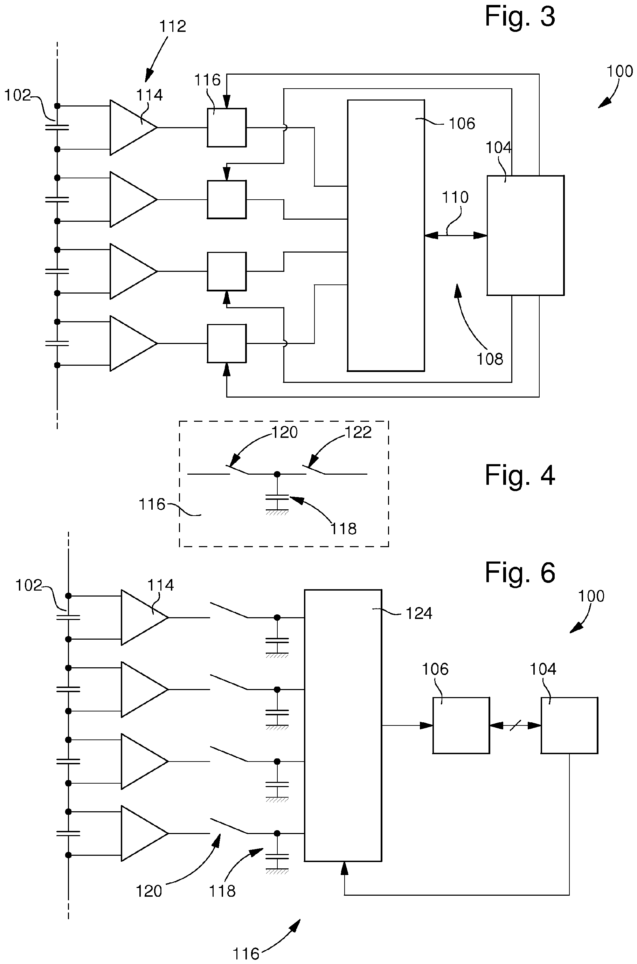

Sur la figure 3, on a représenté de manière schématique un système électrochimique 100 conforme à la présente invention associé à une pile à combustible. Cette dernière comprend une multitude de blocs électrochimiques 102 possédant chacun un pôle négatif et un pôle positif servant de points de connexion. Dans le présent exemple, chaque bloc 102 peut être constitué d'une seule cellule à combustible 102 ou de plusieurs cellules à combustible contiguës. Toutefois, pour simplifier, dans la suite de la description on parlera indifféremment de bloc électrochimique 102 ou de cellule 102 même s'il est possible qu'un bloc électrochimique 102 soit en fait formé de deux cellules 102 ou plus. Les blocs électrochimiques 102 sont reliés en série pour former ce qu'on appelle communément une pile à combustible. Chaque cellule 102 fournit une tension dont la valeur atteint environ 1.2 Volt ce qui, pour un exemple d'une quarantaine de cellules montées en série, donne une tension totale d'environ 48 Volts. L'ensemble du système est commandé par circuit de commande 104.

Dans un premier mode de réalisation, le système comprend une unité de contrôle 106 prévue pour communiquer avec un circuit de commande 104, ladite unité de contrôle 106 prenant la forme d'un microprocesseur. L'unité de contrôle 106 est alimentée par l'alimentation du système électrochimique 100. Il communique avec le circuit de commande 104 via un moyen ou système de communication 108. Ce moyen de communication 108 permet au circuit de commande centrale 104 d'envoyer des instructions à l'unité de contrôle 106. Il permet également à l'unité de contrôle 106 d'envoyer au circuit de commande 104 des informations sur l'état des cellules électrochimiques 102. Le moyen de communication 108 peut être un bus 110 se présentant sous la forme d'un ensemble de fils électriques parallèles. Le bus 110 utilisé peut utiliser le protocole SPI comprenant 3 fils distincts ou tout autre protocole, tel que par exemple le protocole I²C.

Le système électrochimique 100 comprend également des circuits de mesure 112 qui sont chacun constitués par un amplificateur différentiel 114 associé à un bloc électrochimique 102, comme représenté à la figure 3. Ces amplificateurs différentiels 114 fonctionnent avec les tensions fournies par l'alimentation du système. Les amplificateurs différentiels 114 ont deux entrées respectivement reliées au pôle positif et au pôle négatif des différents blocs 102. Les amplificateurs différentiels 114 sont agencés pour former des montages soustracteurs leur permettant de mesurer la différence de potentiel entre la cathode et l'anode d'un bloc électrochimique 102. Dans le présent exemple, chaque bloc électrochimique 102 comprend un amplificateur différentiel 114.

Selon l'invention, la sortie de chaque amplificateur différentiel 114 est connectée à l'unité de contrôle 106 par l'intermédiaire d'un moyen tampon 116. Ce moyen tampon 116 représenté à la figure 4, comprend un condensateur 118 ainsi que des premiers 120 et seconds 122 moyens de commutation. Ces premiers 120 et seconds 122 moyens de commutation sont connectés en série de sorte que la sortie des premiers moyens de commutation 120 soit connectée à l'entrée des seconds moyens de commutation 122. L'entrée des premiers moyens de commutation 120 est connectée à la sortie dudit amplificateur différentiel 114 et la sortie des seconds moyens de commutation 122 est connectée à une entrée de l'unité de contrôle 106. Le condensateur 118 est connecté, à son entrée, au point de connexion entre les premiers 120 et seconds 122 moyens de commutation. La sortie du condensateur 118 est, quant à elle, reliée à la masse du système électrochimique 100. Le moyen tampon 116 se présente alors sous forme d'un T.

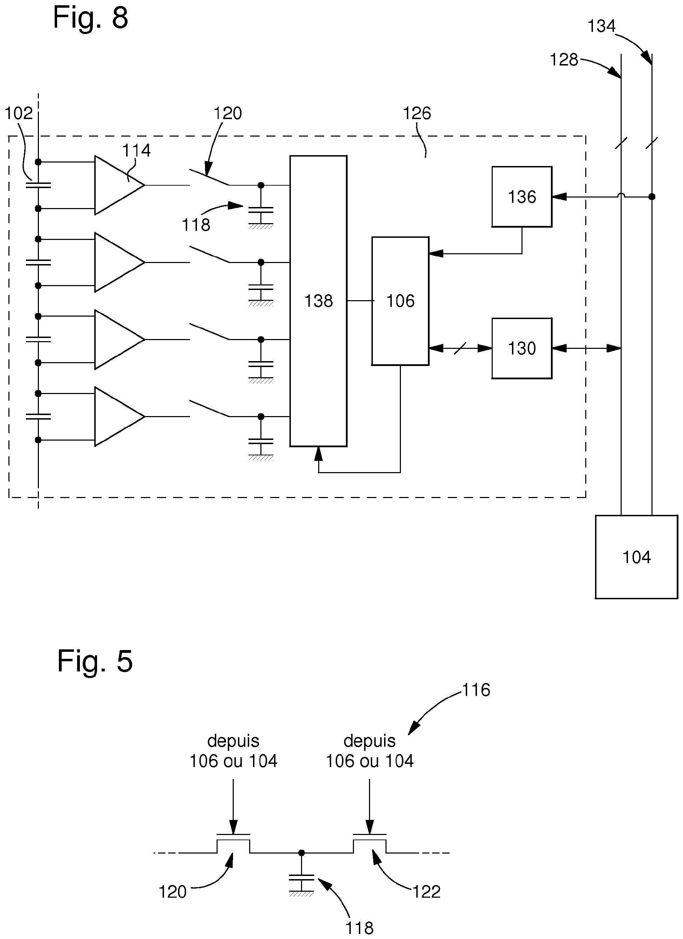

Les premiers 120 et seconds 122 moyens de commutation sont commandables, via un signal de commande, par le circuit de commande centrale 104 ou par l'unité de contrôle 106. Ces premiers 120 et seconds 122 moyens de commutation peuvent se présenter sous la forme d'interrupteurs qui sont commandés. Avantageusement, des transistors sont utilisés pour remplir cette fonction. Ces transistors peuvent être du type P ou N, bipolaire ou FET comme visible à la figure 5.

Le but de ces moyens tampons 116 est de permettre de mesurer la tension représentative de la différence de potentielle de chaque bloc 102 de façon simultanée de sorte à obtenir, à un instant donné, l'état de tous les blocs électrochimiques 102 du système électrochimique 100.

Le système électrochimique 100 fonctionne selon deux modes de fonctionnement. Un premier mode de fonctionnement dit normal est le mode de fonctionnement dans lequel la multitude de blocs électrochimiques 102 de la pile à combustible délivre une tension. Dans ce premier mode de fonctionnement, les premiers 120 et seconds 122 moyens de commutation sont ouverts et donc la connexion électrique n'est pas réalisée entre les amplificateurs différentiels 114, les moyens tampons 116 et l'unité de contrôle 106.

Un second mode de fonctionnement dit « de mesure » est le mode de fonctionnement dans lequel une mesure de la tension représentative de la différence de potentiel aux bornes de chaque bloc électrochimique 102 électrochimique est réalisée pour permettre la surveillance du fonctionnement dudit système électrochimique 100. Dans ce mode de fonctionnement, une première étape consiste à fermer les premiers moyens de commutation 120 de chaque moyen tampon 116. Cette fermeture est commandée par l'unité de contrôle 106 ou, de préférence, par le circuit de commande 104. Cette commande de fermeture est envoyée, via un signal de commande, de façon simultanée à tous les premiers moyens de commutations 120 des moyens tampons 116. Cela permet une connexion électrique, pour chaque moyen tampon 116, entre l'amplificateur différentiel 114 et le condensateur 118 et donc de stocker en même temps, toutes les tensions représentatives de la différence de potentiel présente entre les bornes de chaque bloc électrochimique 102.

Une deuxième étape consiste, une fois ces mesures sauvegardées dans les condensateurs 118 des moyens tampons 116, à ouvrir tous les premiers moyens de commutations 120 des moyens tampons 116, via un signal de commande qui commande l'ouverture, de sorte à isoler les condensateurs 118 et, par conséquent, conserver lesdites mesures. Cette ouverture est commandée par l'unité de contrôle 106 ou, de préférence, par le circuit de commande 104.

Une troisième étape consiste à traiter ces mesures de tensions afin de les convertir en valeur numérique utilisable par le circuit de commande 104. Pour cela, l'unité de contrôle 106 est agencée pour réaliser des conversions du type analogique-numérique et comprend au moins un moyen de conversion du type analogique-numérique (non représenté) pour réaliser lesdites conversions du type analogique-numérique. Ce moyen de conversion analogique-numérique est, par exemple, un convertisseur analogique-numérique classique. Tous les seconds moyens de commutation 122 ont leur sortie connectée à une entrée commune de l'unité de contrôle 106. Cet agencement permet ainsi une numérisation séquentielle des mesures sauvegardées dans les condensateurs 118. Cette numérisation séquentielle est opérée en fermant successivement les seconds moyens de commutation 122 de chaque moyen tampon 116. Cette fermeture est commandée par l'unité de contrôle 106 ou, de préférence, par le circuit de commande 104. La tension sauvegardée est alors transmise à l'unité de contrôle 106 qui reçoit cette donnée et la numérise. Une fois numérisée, cette donnée est stockée dans une mémoire (non représentée) comprise dans l'unité de contrôle 106 ou directement envoyée au circuit de commande 104 via les moyens de communication 108. Les seconds moyens de commutation 122 des moyens tampons 116 du premier bloc électrochimique 102 sont ensuite ouverts et c'est au tour des seconds moyens de commutation 122 des moyens tampons 116 du bloc électrochimique 102 suivant d'être fermés pour permettre la numérisation de la tension sauvegardée dans le condensateur 118 associé et ainsi de suite.

Cette numérisation séquentielle n'est pas un inconvénient car le but principal de la présente invention est d'obtenir, au même instant, toutes les tensions représentatives de la différence de potentiel entre les bornes de chaque bloc électrochimique 102 et non pas d'obtenir ces mesures le plus rapidement possible.

Dans une variante représentée à la figure 6, l'ensemble des seconds moyens de commutations 122 des moyens tampons 116 est remplacé par un multiplexeur 124 dont le nombre d'entrées est égale au nombre d'amplificateurs différentiels 114. Chaque entrée de ce multiplexeur 124 est connectée à la sortie des premiers moyens de commutation 120 d'un moyen tampon 116. Le multiplexeur 124 est commandé par l'unité de contrôle 106 ou par le circuit de commande 104 afin de sélectionner successivement le condensateur 118 qui sera relié à l'unité de contrôle 114.

Le circuit de commande 104 obtient donc des séries de tensions représentant l'état de l'intégralité des blocs électrochimiques 102 au même instant. On obtient ce qui s'apparente à une image de l'état des blocs électrochimiques 102. Comme ce procédé est effectué de façon régulière, il devient facile d'identifier un problème. En effet, en comparant les images reflétant l'état des blocs électrochimiques 102, il est facile de détecter une défaillance du système électrochimique 100. De plus, il devient extrêmement facile de détecter le ou les blocs électrochimiques 102 qui sont défectueux par simple comparaison des différentes images reflétant l'état des blocs électrochimiques 102. Comme les blocs électrochimiques sont sensé avoir un fonctionnement qui évolue en même temps et qu'il est possible d'avoir l'image reflétant l'état des blocs électrochimiques 102 à un instant donné, une comparaison des images permet de voir si un bloc électrochimique 102 évolue différemment des autres.

Avantageusement, il est possible de raccourcir le cycle mesure - numérisation en équipant l'unité de contrôle 106 d'un nombre de moyens de conversion analogique-numérique égal au nombre de blocs électrochimiques 102. Cela permet alors de numériser toutes les mesures de tensions de façon simultanée car tous les seconds moyens de commutation 122 sont fermés en même temps. Cette variante est avantageuse dans le cas d'un système électrochimique 100 ayant un grand nombre de blocs électrochimiques 102.

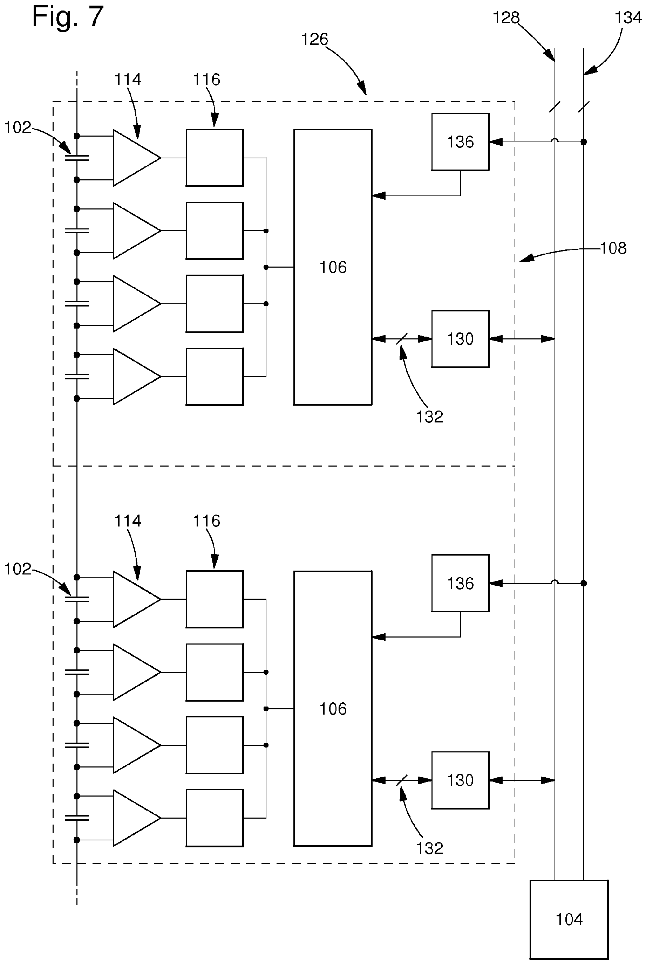

Dans un second mode de réalisation représenté à la figure 7, les blocs électrochimiques 102 sont regroupés dans des groupes ou séries 126 comprenant plusieurs blocs électrochimiques 102. Chaque groupe 112 comprend de préférence le même nombre de blocs électrochimiques 102, et dans le présent exemple chaque groupe 126 comporte quatre blocs électrochimiques 102. Chaque groupe 126 comprend alors une unité de contrôle 106 prévu pour communiquer avec le circuit de commande 104 gérant l'ensemble des groupes 126 via les moyens de communication 108. Ces moyens 108 comprennent un optocoupleur 130 permettant d'isoler ledit groupe 126. Cet optocoupleur 130 est relié à l'unité de contrôle 106 par un bus interne 132 et au circuit de commande 104 par un bus de transfert 128. Chaque bloc électrochimique 102 du groupe est relié à l'unité de contrôle 106 du groupe par un amplificateur différentiel 114 et un moyen tampon 116. Chaque groupe 126 est alimenté via un bus d'alimentation 134. Ce bus d'alimentation 134 consiste en un circuit d'alimentation distinct qui n'est pas dépendant de la tension fournie par le système électrochimique 100. Cela permet aux groupes 126 de toujours fonctionner même si la pile à combustible est éteinte.

Chaque groupe 126 comprend une alimentation électrique propre 136 qui reçoit sont énergie du bus d'alimentation 134 tout en en étant séparée galvaniquement. Grâce à cette caractéristique, chaque groupe 126 peut avoir sa propre tension de référence. Dans le présent exemple, l'isolation galvanique est assurée par un transformateur d'isolation dont le primaire est relié au bus d'alimentation 134 et dont le secondaire fait partie de l'alimentation 134. Dans le présent exemple, l'alimentation 136 fournit aux éléments du groupe 126 une tension positive +2.5V et une tension négative -2.5V relativement à la tension de référence du groupe 126. L'homme du métier comprendra qu'au lieu d'être couplée de façon inductive au bus d'alimentation 134, l'alimentation 136 pourrait alternativement être couplée de façon capacitive à ce bus d'alimentation 134.

Chaque groupe 126 est donc rendu indépendant par le fait qu'il possède sa propre référence de tension. Pour cela, la masse de chaque groupe 126 est reliée à l'une des bornes de connexion de l'un des blocs électrochimiques 102 appartenant audit groupe 126. On comprendra que grâce à cette caractéristique, la différence de potentiel entre les entrées d'un amplificateur différentiel 114 et sa masse ne dépasse pas quelques volts.

De façon préférentielle, le point de connexion servant de référence est pris au milieu de la série de blocs électrochimiques 102 formant le groupe 126. Dans l'exemple, où les groupes 126 comportent quatre blocs électrochimiques 102, la tension de référence est donc prise entre le deuxième et le troisième bloc électrochimique 102. On comprendra de plus que le nombre maximum de blocs électrochimiques 102 par groupe 126 dépend de la différence de potentiel maximale tolérée par un amplificateur différentiel 114 entre sa masse et l'une de ses entrées. Ainsi dans le cas où la différence de potentiel maximale tolérée entre un potentiel d'une cellule et la tension de référence du groupe 126 est de 8V et où chaque bloc électrochimique 102 produit au maximum 1.2V, le nombre maximal de bloc électrochimique 102 par groupe 126 est de 12 (6 X 1.2V. = 7.2V. ; 7.2V. < 8V.).

Le fonctionnement est identique à celui du premier mode de réalisation, c'est-à-dire, qu'il existe un premier mode de fonctionnement dit normal qui est le mode de fonctionnement dans lequel la multitude de blocs électrochimiques 102 de la pile à combustible délivre une tension, et un second mode de fonctionnement dit « de mesure » qui est le mode de fonctionnement dans lequel une mesure de la tension représentative de la différence de potentiel aux bornes de chaque bloc électrochimique 102 est réalisée, par fermeture simultanée de tous les premiers moyens de commutation 120, pour être analyser de sorte à surveiller le fonctionnement de ladite pile à combustible. Les opérations de mesure et de numérisation sont identiques à celles décrites dans le premier mode de réalisation. Les opérations de fermeture et d'ouverture des premiers 120 et seconds 122 moyens de commutation sont commandée par le circuit de commande 104 ou, de préférence, par l'unité de contrôle 106 de chaque groupe 126. On peut aussi prévoir que les premiers moyens de commutation 120 sont commandés par le circuit de commande 104 alors que les seconds moyens de commutation 122 des moyens tampons 116 de chaque groupe sont commandés par l'unité de contrôle 106 dudit groupe 126.

La numérisation des valeurs de tensions représentatives de la différence de potentiel aux bornes des blocs électrochimiques 102 des différents groupes 126 est effectuée séquentiellement et par groupe 126. L'unité de contrôle 106 du premier groupe 126 numérise, via au moins un moyen de conversion analogique-numérique, les valeurs de tensions représentatives de la différence de potentiel aux bornes des blocs électrochimiques 102 de son groupe 126 en utilisant le procédé décrit précédemment. Une fois, cette numérisation terminée, les valeurs numérisées sont envoyées au circuit de commande 104 via le bus interne 132, l'optocoupleur 130 et le bus de transfert 128. Le message comprenant ces données numérisées comprend en outre un marqueur spécifique au groupe dont les données sont issues. Cela permet aux groupes 126 suivants de détecter l'avancée de la numérisation. Dès lors, chaque groupe 126 peut automatiquement commencer la numérisation de ces données dés que la numérisation du groupe 126 le précédent est finie et ainsi de suite.

Dans une première variante de ce second mode de réalisation, la numérisation est réalisée de façon en parallèle. Pour cela, les unités de contrôle 106 des différents groupes 126 numérisent, en même temps, les valeurs de tensions représentatives de la différence de potentiel aux bornes des blocs électrochimiques 102 qui leurs sont associées. Par exemple, soit le cas d'un système ayant dix groupes 126 ayant chacun une unité de contrôle 106 et quatre blocs électrochimiques 102. L'intégralité des mesures est alors numérisée dix fois plus rapidement que pour la numérisation séquentielle. L'envoi des données est par contre toujours réalisé séquentiellement.

Néanmoins, dans une seconde variante, la numérisation est réalisée encore plus rapidement. Pour cela, chaque unité de contrôle 106 comprend un nombre de moyens de conversion analogique-numérique égal au nombre de blocs électrochimiques 102 que le groupe 126 comprend. En conséquence, l'intégralité des mesures des tensions représentatives de la différence de potentiel aux bornes des blocs électrochimiques 102 est numérisée de façon simultanée.

Dans ce second mode de réalisation, il peut également être prévu, comme représenté à la figure 8, que les seconds moyens de commutations 122 des moyens tampons 116 de chaque groupe 126 soient remplacés par un multiplexeur 138 dont le nombre d'entrées est égale au nombre d'amplificateurs différentiels 114 dudit groupe 112. Chaque entrée de ce multiplexeur 138 est connectée à la sortie des premiers moyens de commutation 120 d'un moyen tampon 116. Ce multiplexeur 138 est, de préférence, commandé par l'unité de contrôle 106 du groupe 126. Il permet donc de simplifier le système 100 en ayant moins de connexions et de pistes électriques que dans le cas où les seconds moyens de commutation 122 se présentent sous la forme de transistors dont l'ouverture et la fermeture sont pilotés par une tension.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention défini par les revendications annexées. Par exemple, le système de mesure selon la présente invention peut être appliqué à un système de batterie d'accumulateur comprenant une multitude de cellules électrochimiques.

## Revendications

1. Système électrochimique comprenant une pile de blocs électrochimiques (102) reliés en série, le système (100) étant commandé par un circuit de commande (104) et comprenant une pluralité d'amplificateurs différentiels (114) connectés chacun par deux entrées aux bornes d'un bloc électrochimique afin de fournir une tension représentative de la différence de potentiel entre les bornes dudit bloc électrochimique, chaque tension représentative étant envoyée à une unité de contrôle (106) agencée pour convertir cette tension représentative en une valeur numérique transmise au circuit de commande, le système comprend en outre, entre chaque amplificateur différentiel et l'unité de contrôle, un moyen tampon (116) commandé par le circuit de commande, le moyen tampon étant capable de sauvegarder la tension représentative de la différence de potentiel présente entre les bornes du bloc électrochimique auquel il est relié, et la sauvegarde de la tension étant effectuée simultanément par l'ensemble des moyens tampons.

2. Système électrochimique selon la revendication 1, **caractérisé en ce que** chaque moyen tampon (116) comprend des premiers moyens de commutations (120) et des seconds moyens de commutation (122) montés en séries entre l'amplificateur (114) auquel le moyen tampon est connecté et l'unité de contrôle (106), chaque moyen tampon comprenant en outre un condensateur (118) dont l'entrée est connectée au point de connexion entre les premiers et seconds moyens de commutations et donc la sortie est reliée à un point de référence.

3. Système électrochimique selon la revendication 2, **caractérisé en ce que** l'ensemble des seconds moyens de commutation (122) est regroupé sous la forme d'un multiplexeur (124) dont chaque entrée est connectée aux premiers moyens de commutations (120) d'un moyen tampon (116), la sortie du multiplexeur étant connectée à une entre de l'unité de contrôle (106).

4. Système électrochimique selon les revendications 1 ou 2, **caractérisé en ce que** ladite pile de blocs électrochimiques (102) est subdivisée en différents groupes (126) comprenant plusieurs blocs électrochimiques associés chacun avec un amplificateur différentiel (114) et un moyen tampon (116), et une unité de contrôle (106) reliée à la sortie des moyens tampons associés à chaque blocs électrochimiques du groupe, et **en ce que** chaque groupe a sa propre référence de tension.

5. Système électrochimique selon la revendication 4, **caractérisé en ce que** la référence de tension de chaque groupe (126) est prise sur l'une des bornes d'un bloc électrochimique (102) appartenant audit groupe.

6. Système électrochimique selon les revendications 4 ou 5, **caractérisé en ce que** les seconds moyens de commutation (122) des blocs électrochimiques (102) appartenant au même groupe (126) sont regroupés sous la forme d'un multiplexeur (124) dont chaque entrée est connectée aux premiers moyens de commutations (120) d'un moyen tampon (116), la sortie du multiplexeur étant connectée à une entrée de l'unité de contrôle (106) dudit groupe.

7. Système électrochimique selon l'une des revendications 4 à 6, **caractérisée en ce que** l'unité de contrôle (106) de chaque groupe (126) est reliée au circuit de commande (104) par l'intermédiaire de moyens de communication (108).

8. Système électrochimique selon l'une des revendications 2 à 7, **caractérisée en ce que** les premiers moyens de commutations (120) de chaque moyen tampon (116) se présentent sous la forme d'un transistor piloté par un signal de commande.

9. Système électrochimique selon l'une des revendications 2 à 5, **caractérisée en ce que** les seconds moyens de commutations (120) de chaque moyen tampon (116) se présentent sous la forme d'un transistor piloté par un signal de commande.

10. Système électrochimique selon les revendications 8 ou 9, **caractérisé en ce que** le signal de commande de chaque transistor est envoyé par le circuit de commande (104).

11. Système électrochimique les revendications 8 ou 9, **caractérisé en ce que** le signal de commande de chaque transistor est envoyé par l'unité de contrôle (106).

12. Système électrochimique selon l'une des revendications 1 à 3, **caractérisée en ce que** l'unité de contrôle (106) comprend au moins un moyen de conversion analogique numérique agencé pour numériser la valeur de la tension représentative de la différence de potentiel présente entre les bornes de chaque bloc électrochimique (102).

13. Système électrochimique selon la revendication 12, **caractérisée en ce que** l'unité de contrôle (106) comprend un nombre de moyens de conversion analogique numérique égale au nombre de moyens tampons (116), chaque moyen tampon étant relié à un moyen de conversion analogique numérique.

14. Système électrochimique selon les revendications 2 ou 4 ou 5, **caractérisée en ce que** l'unité de contrôle (106) de chaque groupe (126) comprend au moins un moyen de conversion analogique numérique agencé pour numériser la valeur de la tension représentative de la différence de potentiel présente entre les bornes de chaque bloc électrochimique (102) dudit groupe.

15. Système électrochimique selon la revendication 14, **caractérisée en ce que** l'unité de contrôle (106) de chaque groupe (126) comprend un nombre de moyens de conversion analogique numérique égal au nombre de moyens tampons (116) dudit groupe, chaque moyen tampon étant relié à un moyen de conversion analogique numérique.

16. Procédé de gestion d'un système électrochimique (100) comprenant une pile de blocs électrochimiques (102) reliés en série, le système étant commandé par un circuit de commande (104) et comprenant une pluralité d'amplificateurs différentiels (114) connectés chacun par deux entrées aux bornes d'un bloc électrochimique afin de fournir une tension représentative de la différence de potentiel présente entre les bornes dudit bloc électrochimique, chaque tension représentative étant envoyée à une unité de contrôle (106) agencée pour convertir cette tension représentative en une valeur numérique transmise au circuit de commande, le système comprenant en outre, entre chaque amplificateur différentiel et l'unité de contrôle, un moyen tampon (116) commandé parle circuit de commande, ledit moyen tampon comprenant un condensateur (118) connecté à son entrée, à la sortie de l'amplificateur différentiel par un premier moyen de commutation (120) et à l'unité de contrôle par un second moyen de commutation (122) et à sa sortie, à la masse du système, ledit système fonctionnant selon un premier mode de fonctionnement dit normal dans lequel les premier et second moyens de commutations sont ouverts et un deuxième mode de fonctionnement dit de mesure dans lequel les étapes suivantes sont réalisées :
- fermer, simultanément, les premier moyens de commutations (120) de chaque bloc électrochimique ; et
- sauvegarder, dans chaque condensateur (118), la tension représentative de la différence de potentiel présente entre les bornes du bloc électrochimique auquel ledit condensateur est relié ; et
- ouvrir, simultanément, les premier moyens de commutations (120) de chaque bloc électrochimique ; et
- traiter les valeurs de tension représentative de la différence de potentiel présente entre les bornes de chaque bloc électrochimique en les transmettant à l'unité de contrôle par action sur les seconds moyens de commutation (122) de chaque moyen tampon.

17. Procédé selon la revendication 16, **caractérisé en ce que** l'étape de traitement des valeurs de tension représentative de la différence de potentiel présente entre les bornes de chaque bloc électrochimique consiste à fermer séquentiellement sur les seconds moyens de commutation (122) de chaque moyen tampon (116) afin de transférer la valeur sauvegarder dans chaque condensateur vers l'unité de contrôle (106).

18. Procédé de gestion d'un système électrochimique selon les revendications 16 ou 17, **caractérisé en ce que** ladite pile de blocs électrochimiques (102) est subdivisée en différents groupes (126) comprenant plusieurs blocs électrochimiques associés chacun avec un amplificateur différentiel (114) et un moyen tampon (116), et une unité de contrôle (106) reliée à la sortie des moyens tampon, chaque groupe ayant sa propre référence de tension et **en ce que** les étapes du deuxième mode de fonctionnement sont réalisées pour chaque groupe de façon séquentielle.

19. Procédé de gestion d'un système électrochimique selon la revendication 18, **caractérisé en ce que** les étapes du deuxième mode de fonctionnement sont réalisées, pour chaque groupe, de façon simultanée.

## Patentansprüche

1. Elektrochemisches System mit übereinanderliegenden, in Reihe geschalteten elektrochemischen Blöcken (102), wobei das System (100) durch eine Steuerschaltung (104) gesteuert wird und mit mehreren Differenzverstärkern (114), die jeweils über zwei Eingänge mit den Anschlüssen eines elektrochemischen Blocks verbunden sind, um eine Spannung bereitzustellen, die die Potentialdifferenz zwischen den Anschlüssen des elektrochemischen Blocks darstellt, wobei jede repräsentative Spannung an eine Steuereinheit (106) geschickt wird, die dafür ausgelegt ist, diese repräsentative Spannung in einen an die Steuerschaltung übertragenen digitalen Wert umzusetzen, wobei das System ferner zwischen jedem Differenzverstärker und der Steuereinheit ein von der Steuerschaltung gesteuertes Puffermittel (116) umfasst, wobei das Puffermittel geeignet ist, die die Potentialdifferenz darstellende Spannung zu sichern, die zwischen den Anschlüssen des elektrochemischen Blocks, mit dem es verbunden ist, vorhanden ist, wobei die Sicherung der Spannung durch sämtliche Puffermittel gleichzeitig ausgeführt wird.

2. Elektrochemisches System nach Anspruch 1, **dadurch gekennzeichnet, dass** jedes Puffermittel (116) erste Schaltmittel (120) und zweite Schaltmittel (122) umfasst, die zwischen dem Verstärker (114), mit dem das Puffermittel verbunden ist, und der Steuereinheit (106) in Reihe geschaltet sind, wobei jedes Puffermittel ferner einen Kondensator (118) umfasst, dessen Eingang mit dem Verbindungspunkt zwischen dem ersten und dem zweiten Schaltmittel verbunden ist und dessen Ausgang mit einem Referenzpunkt verbunden ist.

3. Elektrochemisches System nach Anspruch 2, **dadurch gekennzeichnet, dass** alle der zweiten Schaltmittel (122) in Form eines Multiplexers (124) gruppiert sind, von dem jeder Eingang mit den ersten Schaltmitteln (120) mittels eines Puffermittels (116) verbunden ist, wobei der Ausgang des Multiplexers mit einem Eingang der Steuereinheit (106) verbunden ist.

4. Elektrochemisches System nach den Ansprüchen 1 oder 2, **dadurch gekennzeichnet, dass** die übereinanderliegenden elektrochemischen Blöcke (102) in verschiedene Gruppen (126) unterteilt sind, umfassend mehrere elektrochemische Blöcke, die jeweils einem Differenzverstärker (114) und einem Puffermittel (116) zugeordnet sind, und eine Steuereinheit (106), die mit dem Ausgang der Puffermittel verbunden ist, die jedem elektrochemischem Block der Gruppe zugeordnet sind, und dass jede Gruppe ihre eigene Spannungsreferenz besitzt.

5. Elektrochemisches System nach Anspruch 4, **dadurch gekennzeichnet, dass** die Spannungsreferenz jeder Gruppe (126) an einem der Anschlüsse eines elektrochemischen Blocks (102), der zu der Gruppe gehört, abgenommen wird.

6. Elektrochemisches System nach den Ansprüchen 4 oder 5, **dadurch gekennzeichnet, dass** die zweiten Schaltmittel (122) der elektrochemischen Blöcke (102), die zu derselben Gruppe (126) gehören, in Form eines Multiplexers (124) gruppiert sind, wovon jeder Eingang mit den ersten Schaltmitteln (120) eines Puffermittels (116) verbunden ist, wobei der Ausgang des Multiplexers mit einem Eingang der Steuereinheit (106) der Gruppe verbunden ist.

7. Elektrochemisches System nach einem der Ansprüche 4 bis 6, **dadurch gekennzeichnet, dass** die Steuereinheit (106) jeder Gruppe (126) mit der Steuerschaltung (104) über Kommunikationsmittel (108) verbunden ist.

8. Elektrochemisches System nach einem der Ansprüche 2 bis 7, **dadurch gekennzeichnet, dass** die ersten Schaltmittel (120) jedes Puffermittels (116) die Form eines durch ein Steuersignal gesteuerten Transistors aufweisen.

9. Elektrochemisches System nach einem der Ansprüche 2 bis 5, **dadurch gekennzeichnet, dass** die zweiten Schaltmittel (120) jedes Puffermittels (116) die Form eines durch ein Steuersignal gesteuerten Transistors aufweisen.

10. Elektrochemisches System nach den Ansprüchen 8 oder 9, **dadurch gekennzeichnet, dass** das Steuersignal jedes Transistors von der Steuerschaltung (104) geschickt wird.

11. Elektrochemisches System nach den Ansprüchen 8 oder 9, **dadurch gekennzeichnet, dass** das Steuersignal jedes Transistors von der Steuereinheit (106) geschickt wird.

12. Elektrochemisches System nach einem der Ansprüche 1 bis 3, **dadurch gekennzeichnet, dass** die Steuereinheit (106) mindestens ein Analog/Digital-Umsetzungsmittel umfasst, das dafür ausgelegt ist, den Wert der die Potentialdifferenz repräsentierenden Spannung zu digitalisieren, die an den Anschlüssen jedes elektrochemischen Blocks (102) vorhanden ist.

13. Elektrochemisches System nach Anspruch 12, **dadurch gekennzeichnet, dass** die Steuereinheit (106) eine Anzahl von Analog/Digital-Umsetzungsmitteln umfasst, die gleich der Anzahl der Puffermittel (116) ist, wobei jedes Puffermittel mit einem Analog/Digital-Umsetzungsmittel verbunden ist.

14. Elektrochemisches System nach den Ansprüchen 2 oder 4 oder 5, **dadurch gekennzeichnet, dass** die Steuereinheit (106) jeder Gruppe (126) mindestens ein Analog/Digital-Umsetzungsmittel umfasst, das dafür ausgelegt ist, den Wert der die Potentialdifferenz repräsentierenden Spannung zu digitalisieren, die zwischen den Anschlüssen jedes elektrochemischen Blocks (102) der Gruppe vorhanden ist.

15. Elektrochemisches System nach Anspruch 14, **dadurch gekennzeichnet, dass** die Steuereinheit (106) jeder Gruppe (126) eine Anzahl von Analog/Digital-Umsetzungsmitteln umfasst, die gleich der Anzahl von Puffermitteln (116) der Gruppe ist, wobei jedes Puffermittel mit einem Analog/Digital-Umsetzungsmittel verbunden ist.

16. Verfahren zum Steuern eines elektrochemischen Systems (100) mit übereinanderliegenden, in Reihe geschalteten elektrochemischen Blöcken (102), wobei das System durch eine Steuerschaltung (104) gesteuert wird und mit mehreren Differenzverstärkern (114), die jeweils durch zwei Eingänge mit den Anschlüssen eines elektrochemischen Blocks verbunden sind, um eine die Potentialdifferenz darstellende Spannung bereitzustellen, die zwischen den Anschlüssen des elektrochemischen Blocks vorhanden ist, wobei jede repräsentative Spannung an eine Steuereinheit (106) geschickt wird, die dafür ausgelegt ist, diese repräsentative Spannung in einen an die Steuerschaltung übertragenen digitalen Wert umzusetzen, wobei das System ferner zwischen jedem Differenzverstärker und der Steuereinheit ein von der Steuerschaltung gesteuertes Puffermittel (116) umfasst, wobei das Puffermittel einen Kondensator (118) umfasst, der an seinem Eingang mit dem Ausgang des Differenzverstärkers durch ein erstes Schaltmittel (120) und mit der Steuereinheit durch ein zweites Schaltmittel (122) und an seinem Ausgang mit der Masse des Systems verbunden ist,
wobei das System in einer ersten sogenannten normalen Betriebsart arbeitet, in der das erste und das zweite Schaltmittel geöffnet sind, und in einer zweiten sogenannten Messbetriebsart, in der die folgenden Schritte ausgeführt werden:
- Gleichzeitiges Schließen der ersten Schaltmittel (120) jedes elektrochemischen Blocks; und
- Sichern der Spannung, die die Potentialdifferenz darstellt, die zwischen den Anschlüssen des elektrochemischen Blocks vorhanden ist, mit dem der Kondensator verbunden ist, in jedem Kondensator (118); und
- Gleichzeitiges Öffnen der ersten Schaltmittel (120) jedes elektrochemischen Blocks; und
- Verarbeiten der Spannungswerte, die die Potentialdifferenz darstellen, die zwischen den Anschlüssen jedes elektrochemischen Blocks vorhanden ist, indem sie an die Steuereinheit durch Einwirkung auf die zweiten Schaltmittel (122) jedes Puffermittels übertragen werden.

17. Verfahren nach Anspruch 16, **dadurch gekennzeichnet, dass** der Schritt des Verarbeitens der Spannungswerte, die die Potentialdifferenz darstellen, die zwischen den Anschlüssen jedes elektrochemischen Blocks vorhanden ist, darin besteht, nacheinander die zweiten Schaltmittel (122) jedes Puffermittels (116) zu schließen, um den gesicherten Wert in jedem Kondensator an die Steuereinheit (106) zu übertragen.

18. Verfahren zum Steuern eines elektrochemischen Systems nach den Ansprüchen 16 oder 17, **dadurch gekennzeichnet, dass** die übereinanderliegenden elektrochemischen Blöcke (102) in verschiedene Gruppen (126) unterteilt sind, die mehrere, jeweils einem Differenzverstärker (114) und einem Puffermittel (116) zugeordnete elektrochemische Blöcke und eine Steuereinheit (106) umfassen, die mit dem Ausgang der Puffermittel verbunden ist, wobei jede Gruppe ihre eigene Spannungsreferenz aufweist, und dass die Schritte der zweiten Betriebsart für jede Gruppe nacheinander ausgeführt werden.

19. Verfahren zum Steuern eines elektrochemischen Systems nach Anspruch 18, **dadurch gekennzeichnet, dass** die Schritte der zweiten Betriebsart für jede Gruppe gleichzeitig ausgeführt werden.

## Claims

1. Electrochemical system including a stack of electrochemical units (102) connected in series, wherein the system (100) is controlled by a control circuit (104) and includes a plurality of differential amplifiers (114), each connected by two inputs to the terminals of an electrochemical unit, so as to supply a voltage representative of the potential difference between the terminals of said electrochemical unit, each representative voltage is sent to a control unit (106) arranged for converting said representative voltage into a numerical value transmitted to the control circuit, the system further includes, between each differential amplifier and the control unit, a buffer means (116) controlled by the control circuit, the buffer means being capable of saving the voltage representative of the potential difference present between the terminals of the electrochemical unit connected thereto, and the voltage being saved simultaneously by all of the buffer means.

2. Electrochemical system according to claim 1, **characterized in that** each buffer means (116) includes first switching means (120) and second switching means (122) series connected between the amplifier (114) to which the buffer means is connected and the control unit (106), wherein each buffer means further includes a capacitor (118), the input of which is connected to the point of connection between the first and second switching means, and thus the output is connected to a reference point.

3. Electrochemical system according to claim 2, **characterized in that** all of the second switching means (122) are grouped together in the form of a multiplexer (124), each input of which is connected to the first switching means (120) of a buffer means (116), the output of the multiplexer being connected to an input of the control unit (106).

4. Electrochemical system according to claims 1 or 2, **characterized in that** said stack of electrochemical units (102) is subdivided into different groups (126) including several electrochemical units, each associated with a differential amplifier (114) and a buffer means (116), and a control unit (106) connected to the output of the buffer means associated with each electrochemical unit of the group, and **in that** each group has its own voltage reference.

5. Electrochemical system according to claim 4, **characterized in that** the voltage reference of each group (126) is taken across one of the terminals of an electrochemical unit (102) belonging to said group.

6. Electrochemical system according to claims 4 or 5, **characterized in that** the second switching means (122) of the units belonging to the same group (126) are grouped together in the form of a multiplexer (124), each input of which is connected to the first switching means (120) of a buffer means (116), and the output of the multiplexer is connected to an input of the control unit (106) of said group.

7. Electrochemical system according to claims 4 to 6, **characterized in that** the control unit (106) of each group (126) is connected to the control circuit (104) via switching means (108).

8. Electrochemical system according to any of claims 2 to 7, **characterized in that** the first switching means (120) of each buffer means (116) takes the form of a transistor controlled by a control signal.

9. Electrochemical system according to any of claims 2 to 5, **characterized in that** the second switching means (120) of each buffer means (116) takes the form of a transistor controlled by a control signal.

10. Electrochemical system according to claims 8 or 9, **characterized in that** the control signal for each transistor is sent by the control circuit (104).

11. Electrochemical system according to claims 8 or 9, **characterized in that** the control signal for each transistor is sent by the control unit (106).

12. Electrochemical system according to any of claims 1 to 3, **characterized in that** the control unit (106) includes at least one analogue-digital conversion means, arranged for digitizing the value of the voltage representative of the potential difference present between the terminals of each electrochemical unit (102).

13. Electrochemical system according to claim 12, **characterized in that** the number of analogue-digital conversion means included in the control unit (106) is equal to the number of buffer means (116), and each buffer means is connected to an analogue-digital conversion means.

14. Electrochemical system according to claims 2 or 4 or 5, **characterized in that** the control unit (106) of each group (126) includes at least one analogue-digital conversion means, arranged for digitizing the value of the voltage representative of the potential difference present between the terminals of each electrochemical unit (102) of said group.

15. Electrochemical system according to claim 14, **characterized in that** the number of analogue-digital conversion means included in the control unit (106) of each group (126) is equal to the number of buffer means (116) of said group, and each buffer means is connected to an analogue-digital conversion means.

16. Method for managing an electrochemical system (100) including a stack of electrochemical units (102) connected in series, wherein the system (100) is controlled by a control circuit (104) and includes a plurality of differential amplifiers (114), each connected by two inputs to the terminals of an electrochemical unit, so as to supply a voltage representative of the potential difference between the terminals of said electrochemical unit, each representative voltage is sent to a control unit (106), arranged for converting said representative voltage into a numerical value transmitted to the control circuit, the system further including between each differential amplifier and the control unit, a buffer means (116) controlled by the control circuit, said buffer including a capacitor (118) connected, at the input thereof, to the output of the differential amplifier by a first switching means (120) and to the control unit by a second switching means (122), and at the output thereof, to the system earth, said system operating in a first, normal, operating mode, in which the first and second switching means are open and a second, measuring, operating mode, in which the following steps are performed:
- the first switching means (120) of each electrochemical unit are simultaneously closed; and
- the voltage representative of the potential difference present between the terminals of the electrochemical unit, to which said capacitor is connected, is saved in each capacitor (118); and
- the first switching means (120) of each electrochemical unit are simultaneously opened; and
- the values of the voltage representative of the potential difference between the terminals of each electrochemical unit are processed by transmission to the control unit, via action on the second switching means (122) of each buffer means.

17. Method according to claim 16, **characterized in that** the step of processing the values of the voltage representative of the potential difference present between the terminals of each electrochemical unit consists in sequentially closing the second switching means (122) of each buffer means (116), so as to transfer the value saved in each capacitor to the control unit (106).

18. Method for managing an electrochemical system according to claims 16 or 17, **characterized in that** said stack of electrochemical units (102) is subdivided into different groups (126) including several electrochemical units, each associated with a differential amplifier (114) and a buffer means (116), and a control unit (106), connected to the output of the buffer means, each group having its own voltage reference and **in that** the steps of the second operating mode are performed sequentially for each group.

19. Method for managing an electrochemical system according to claim 18, **characterized in that** the steps of the second operating mode are performed simultaneously for each group.
